# EUROPEAN PATENT APPLICATION

(11) **EP 4 475 643 A1**
(43) Date of publication of application: **11.12.2024**
(21) Application number: 24177791.1
(22) Date of filing: 23.05.2024
(51) Int. Cl.: H05K 7/14

(54) **SWITCHING CELL WITH CONNECTING DEVICE**

(30) Priority: 05.06.2023 DE 102023114742
(71) Applicant: Valeo eAutomotive Germany GmbH, 91056 Erlangen (DE)
(72) Inventor: Londhe, Ishwar, 91056 Erlangen (DE); Unertl, Alexander, 91056 Erlangen (DE); Ilg, Stefan, 91056 Erlangen (DE); Felber, Bernd, 91056 Erlangen (DE); Oegues, Atahan, 91056 Erlangen (DE); Pearldian, Anderson, 600130 Chennai (IN)
(74) Representative: Valeo Powertrain Systems

(57) **Abstract**

The present invention relates to a switching cell (1) for an automotive vehicle, comprising at least one power module (2, 2A, 2B, 2C), a DC link capacitor (4), and a connecting device (22) between the power module (2, 2A, 2B, 2C) and the DC link capacitor (4), the power module (2) having at least one connecting tab of a first polarity and at least one connecting tab of a second polarity, the connecting tabs being in a same connection plane and separated by a space, the connecting device (22) comprising at least one connecting part (24, 24A, 24B) in contact with the connecting tab of the first polarity (14) and a covering part (26) covering the space between the connecting tabs, the covering part (26) being offset from the connecting part (24, 24A, 24B) perpendicularly to the connection plane.

## Description

The present invention relates to the fields of electronics and electrical engineering, and more particularly to the field of switching cells.

Switching cells are power electronic devices which are capable of generating an alternating current from a direct current. The switching cells can be integrated into motor vehicles, in particular hybrid or electric vehicles, to convert direct current supplied by batteries into alternating current to power the electric motor.

Switching cells usually comprise both a power module and a DC link capacitor, which are connected to each other within the switching cell. The power module contains various power components, while the DC link capacitor is used as a buffer and can balance fluctuations.

In some switching cells, the power module and the DC link capacitor are stacked, with for instance the power module being placed on top of the DC link capacitor when the switching cell is integrated in the vehicle. More recent versions of the switching cells have been developed with the power module and the DC link capacitor positioned side by side, for example parallelly to a floor of the vehicle. In these embodiments, due to the different positioning of the power module relative to the DC link capacitor, new ways of connecting these two components of the switching cell must be found.

Connecting tabs or connecting terminals of the power module are often positioned at a distance from each other to maintain a clearance and creepage distance, as well as to accommodate manufacturing operations such as screwing or the like. Due to the distance between the connecting tabs, the magnetic field is not compensated correctly, which leads to unwanted levels of stray inductance.

The present invention fits into this context by providing a switching cell within which a connecting device is interposed between the power module and the DC link capacitor, thus compensating magnetic fields and offering a connection with limited stray inductance.

In this context, the present invention is directed to a switching cell for an automotive vehicle, comprising at least one power module, a DC link capacitor, and a connecting device between the power module and the DC link capacitor, the power module having at least one connecting tab of a first polarity and at least one connecting tab of a second polarity, the connecting tabs extending from a face of the power module facing the DC link capacitor, the connecting tabs being in a same connection plane and being separated by a space, the connecting device comprising at least one connecting part in contact with the connecting tab of the first polarity and a covering part covering at least the space between the connecting tabs, the covering part being offset from the connecting part perpendicularly to the connection plane.

The switching cell according to the invention is destined to be implemented in a vehicle, for instance a hybrid or electric vehicle, in order to power its electric motor. The switching cell comprises at least one power module which is linked to a DC link capacitor via a connecting device. The switching cell is a flat switching cell rather than a stacked switching cell; here, the DC link capacitor and the power module are side by side, whereas in a stacked switching cell the power module is stacked over the DC link capacitor when the switching cell is installed in the vehicle.

The power module has connecting tabs of different polarities, which correspond to at least a minus terminal and a plus terminal. The connecting tab of the first polarity can be a negative connecting tab and the connecting tab of the second polarity a positive connecting tab, or conversely. The connecting tabs are separated by a space; in other words, they are not contiguous. This space is located between the connecting tabs and is in the same connection plane they extend in.

The connecting device extends between the power module and the DC link capacitor, in a space between their respective main bodies. It has a connecting part in contact with the connecting tab of the first polarity, here the negative connecting tab. The connecting device also has a covering part which extends from one connecting tab to the other, meaning from the connecting tab of the first polarity and the connecting tab of the second polarity; the connecting device thus covers the space between these two connecting tabs. The resulting increased overlap between the connecting tabs provides a current path, thus compensating the magnetic fields to solve the stray inductance issues.

The connecting device is not flat, in that there is an offset between the connecting part and the covering part. As a result, the connecting part and the covering part mainly extend in two substantially parallel planes.

The connection of the power module and the DC link capacitor within the switching cell according to the invention is secured, thus limiting the risks of short circuits.

According to an optional characteristic of the invention, the DC link capacitor has at least one linking tab extending from one of its sides facing the power module, the linking tab being in contact with the connecting tab of the second polarity of the power module.

In other words, the power module and the DC link capacitor are directly connected to each other via a contact between their respective connecting tab of the second polarity and linking tab. Both of these tabs extend in the space between the main body of the power module and the main body of the DC link capacitor.

According to an optional characteristic of the invention, the covering part of the connecting device is at a non-zero distance from the linking tab of the DC link capacitor.

This means that the connecting device and the linking tab do not touch, in order to avoid short circuits.

According to an optional characteristic of the invention, the linking tab is layered between the connecting tab of the second polarity and the connecting device.

In other words, the connecting device is superposed over the linking tab, itself being superposed over the connecting tab of the second polarity.

According to an optional characteristic of the invention, the power module comprises one connecting tab of the first polarity and two connecting tabs of the second polarity, the connecting tab of the first polarity being arranged between the two connecting tabs of the second polarity.

As a result, in the connection plane the positive connecting tab is surrounded by the two negative connecting tabs. In such embodiments, the linking tab of the DC link capacitor thus extends between the two connecting tabs of the second polarity, meaning the two negative connecting tabs.

According to an optional characteristic of the invention, the connecting device comprises two connecting parts each in contact with one of the connecting tabs of the second polarity, the two connecting parts extending from opposite sides of the covering part and being in a same plane.

The connecting device has a flat middle portion corresponding to the covering part, as well as a first bent portion and a second bent portion respectively joining each connecting part to the covering part. The bent portions extend from opposite sides of the flat middle portion, so that each of the connecting parts is in contact with one of the connecting tabs of the second polarity. As these two connecting tabs of the second polarity are both in the connection plane, to ensure the connection between them and the connecting device the two connecting parts are also in a same plane, which is different from the plane in which the covering part extends due to the offset.

According to an optional characteristic of the invention, the switching cell comprises a plurality of power modules, the connecting device having a shared body and a plurality of branches extending from the shared body, each branch being in contact with the connecting tab of the first polarity of a given power module and covering at least the space between the connecting tabs of the given power module.

The power modules are aligned alongside a side of the DC link capacitor towards which the connecting tabs extend. There are for example three power modules aligned facing the DC link capacitor.

The connecting device has a shared body extending along the plurality of the power modules, with one branch extending from this shared body towards each power module; there is a first branch for the first power module, a second branch for the second power module and a third branch for the third power module. The branch of the connecting device corresponds to its part which comprises the connecting part and the covering part.

According to an optional characteristic of the invention, the switching cell comprises at least one insulating means, the insulating means covering at least part of the covering part of the connecting device.

The insulating means is used to prevent clearance and creepage issues within the switching cell.

According to an optional characteristic of the invention, the covering part of the connecting device has an upper side, a lower side and an edge joining the upper side and the lower side, this edge being substantially parallel to the face of the power module from which the connecting tabs extend and the edge facing this face, the insulating means covering at least partly each of the lower side, the upper side and the edge of the covering part of the connecting device.

As such, the insulating means has a portion arranged between the connecting device and the connecting tab of the second polarity to prevent short circuits between these two components.

According to an optional characteristic of the invention, the switching cell comprises a plurality of insulating means, each insulating means covering at least part of the covering part of one of the branches of the connecting device.

There is a plurality of insulating means when there is a plurality of power modules each connected to one of the branches of the connecting device. For a given branch, the insulating means covers most of the covering part but not the connecting parts on its sides; the bent portions between the covering part and the connecting parts are free of insulating means. This allows for an insulating means which is mainly flat, facilitating its manufacturing.

According to an optional characteristic of the invention, the insulating means is an insulation layer, e.g. an insulating paper, coating, etc.

When the insulating means is an insulating paper, it may be bent over an edge of the connecting device. To ensure that it stays in place on the connecting device, the insulating means can be glued to the connecting device.

The coating is an alternative to the insulating paper, which allows for a thinner insulating means.

According to an optional characteristic of the invention, the DC link capacitor has at least one positioning pin and the connecting device has at least one positioning hole, the positing pin and the positioning hole cooperating together.

The positing pin and the positioning hole cooperate in order to secure the connecting device on the DC link capacitor. The positioning pin is located on the main body of the DC link capacitor whereas the positioning hole is located on the shared body of the connecting device, on an opposite side with respect to the side from which the branches extend.

In alternative embodiments, the connecting device has at least one positioning pin and the DC link capacitor has at least one positioning hole.

According to an optional characteristic of the invention, the connecting device is made of metal.

The metal used to make the connecting device can be copper or aluminium.

According to an optional characteristic of the invention, the connecting device has a thickness between 0,3 and 0,9 millimetre.

Preferably, the thickness of the connecting device is 0,6 millimetre. Such thickness is chosen so that the connecting device can be easily bent to present the required offset between the connecting part and the covering part, in case there is a need to compensate manufacturing tolerances between the tabs.

According to an optional characteristic of the invention, the connecting device is welded to at least one of the connecting tabs of the power module.

Other characteristics, details and advantages of the invention will become clearer on reading the following description, on the one hand, and several examples of realisation given as an indication and without limitation with reference to the schematic figures annexed, on the other hand, on which:
[Fig. 1] is a schematic representation of a switching cell according to the invention, the switching cell comprising a power module, a DC link capacitor and a connecting device, the DC link capacitor and the power module being positioned side by side;
[Fig. 2] is an isolated view of the connecting device of the switching cell of figure 1;
[Fig. 3] is a top view of the connecting device, connecting tabs of the power module, linking tabs of the DC link capacitor, these parts having been spread out for illustrative purposes;
[Fig. 4] is a cross-section view of one of the connecting tabs of figure 3, one of the linking tabs, the connecting device and an insulating means.

The characteristics, variants and different modes of realisation of the invention may be associated with each other in various combinations, in so far as they are not incompatible or exclusive with each other. In particular, variants of the invention comprising only a selection of features subsequently described in from the other features described may be imagined, if this selection of features is enough to confer a technical advantage and/or to differentiate the invention from prior art.

Like numbers refer to like elements throughout the figures.

In the following description, the designations "longitudinal", "transversal" and "vertical" refer to the orientation of the switching cell according to the invention. A longitudinal direction corresponds to a direction in which the power module, the DC link capacitor and a space between their main bodies are aligned, the power module and the DC link capacitor being positioned side to side, this longitudinal direction being parallel to a longitudinal axis L of a coordinate system L, V, T shown in the figures. A transversal direction corresponds to a direction in which the connecting device mainly extends in the space between the main bodies, this transversal direction being parallel to a transverse axis T of the coordinate system L, V, T, and perpendicular to the longitudinal axis L. Finally, a vertical direction corresponds to a vertical axis V of the coordinate system L, V, T, the vertical axis V being perpendicular to the longitudinal axis L and the transversal axis T.

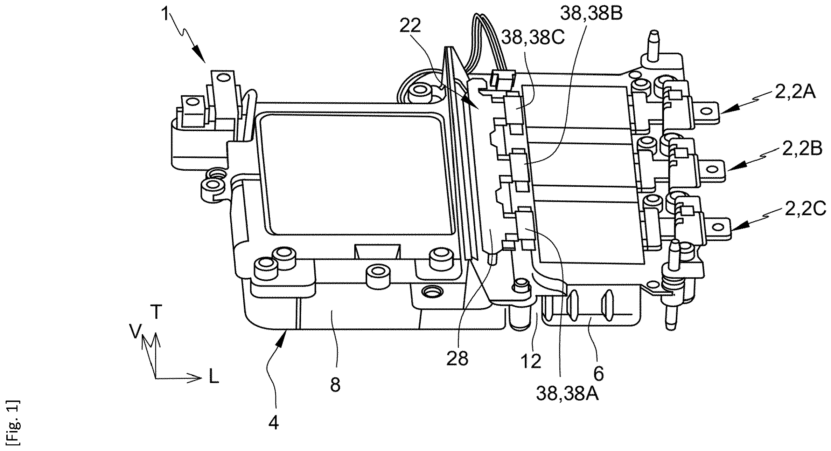

Figures 1 to 4 illustrate, in a schematic way, a switching cell 1 according to the invention. The switching cell 1 is configured to be installed in an automotive vehicle such as an electric or a hybrid vehicle, its purpose being to generate an alternate current suitable for powering a motor of the vehicle. To this end, the switching cell 1 comprises at least one power module 2 housing various power components and a DC link capacitor 4 where energy can be stored.

As is illustrated on the figures, in the present embodiment the at least one power module 2 corresponds to three power modules 2, with a first power module 2A, a second power module 2B and a third power module 2C. Unless it is mentioned otherwise, everything which will be described hereinafter in relation with one of these power modules 2A, 2B, 2C can be applied to any or all power modules 2A, 2B, 2C.

In the switching cell 1, the power module 2 and the DC link capacitor 4 are positioned side by side, as can be seen in Figure 1. More precisely, the power module 2 has a main body 6 and the DC link capacitor 4 has a main body 8, the main body 6 of the power module 2 and the main body 8 of the DC link capacitor 4 being alongside each other. When there are three power modules 2A, 2B, 2C, they are aligned so that a front face 10 of each of their main bodies 6 faces the DC link capacitor 4, the front faces 10 of the power modules 2A, 2B, 2C being in the same plane.

The main body 6 of the power module 2 and the main body 8 of the DC link capacitor 4 face each other but they do not touch; they are separated by a corridor 12, which is a space between the main body 6 of the power module 2 and the main body 8 of the DC link capacitor 4. This corridor 12 mainly extends according to a transverse direction T, while the power module 2, the corridor 12 and the DC link capacitor 4 are aligned according to a longitudinal direction L which corresponds to a main direction of the switching cell 1.

The corridor 12 is the part of the switching cell 1 where the power module 2 and the DC link capacitor 4 are connected to each other, as will now be described.

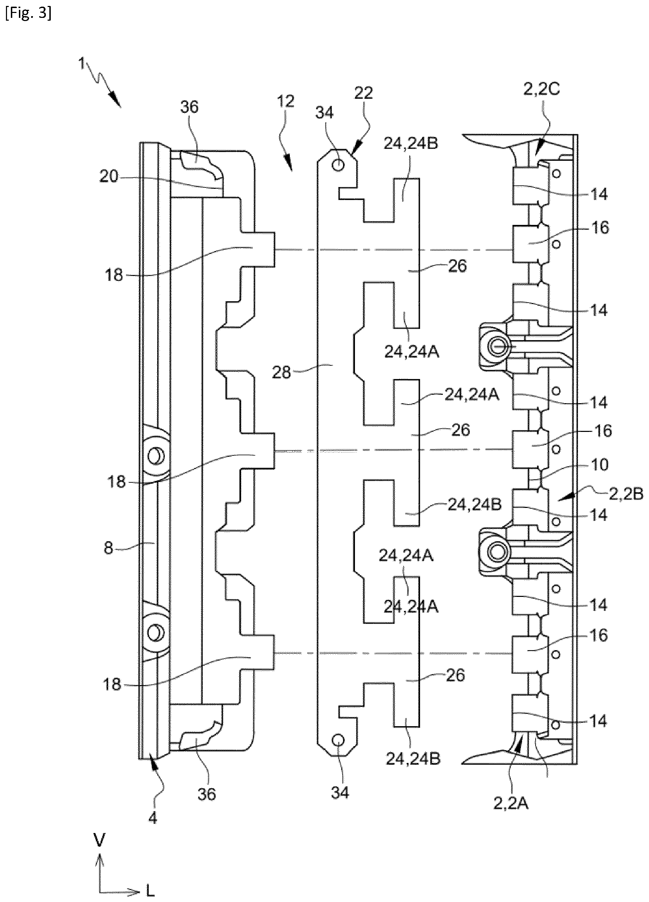

As is particularly visible on Figure 3, the power module 2 comprises connecting tabs, among which at least one connecting tab of a first polarity 14 and at least one connecting tab of a second polarity 16. The connecting tab of the first polarity 14 is here a minus terminal of the power module 2, while the connecting tab of the second polarity 16 is a plus terminal. The connecting tabs 14, 16 are of a rectangular shape. They extend in the corridor 12 from the front face 10 of the main body 6 of the power module 2, substantially perpendicularly to this front face 10 and in the direction of the DC link capacitor 4. They mainly extend in a longitudinal-transversal plane which corresponds to a connection plane of the switching cell 1.

More precisely, the power module 2 comprises two connecting tabs of the first polarity 14 and a single connecting tab of the second polarity 16, this connecting tab of the second polarity 16 being placed in the middle of the two connecting tabs of the first polarity 14 within the connection plane. As a result, for a given power module 2 there is a single plus terminal arranged between two minus terminals.

The connecting tabs 14, 16 are separated by a space S in the connection plane so that they are not in contact with each other, which would cause short circuits. There is thus a first space S1 between one of the connecting tabs of the first polarity 14 and the connecting tab of the second polarity 16, and a second space S2 between this connecting tab of the second polarity 16 and the other connecting tab of the first polarity 14.

The DC link capacitor 4 is equipped with at least one linking tab 18. Preferably, the DC link capacitor 4 has as many linking tabs 18 as there are power modules 2; in the present embodiment, the DC link capacitor 4 comprises three linking tabs 18.

Each linking tab 18 extends from a front side 20 of the DC link capacitor 4 which faces the front face 10 of the power module and participates in the delimitation of corridor 12. The linking tab 18 extends from this front side 20 substantially perpendicularly to it, in a plane that is parallel to the connection plane of the connecting tabs 14, 16.

The linking tab 18 is in contact with the power module 2; more particularly, the linking tab 18 is in contact with the connecting tab of the second polarity 16 of the power module 2. In other words, the linking tab 18 and the connecting tab of the second polarity 16 both extend in the corridor 12 so that they overlay. When there are two connecting tabs of the first polarity 14, the linking tab 18 extends between them according to the transversal direction D.

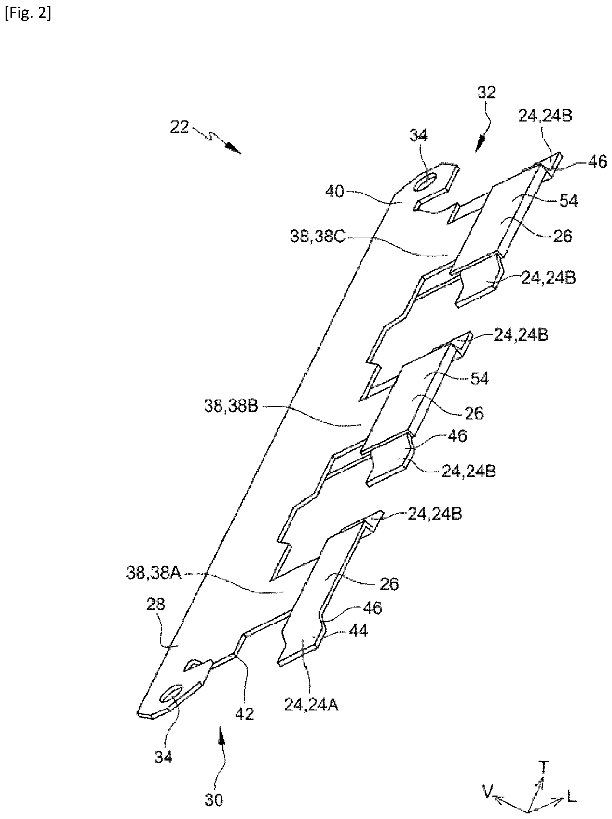

According to the invention, the switching cell 1 comprises a connecting device 22 which mainly extends between the power module 2 and the DC link capacitor 4, at least partly in corridor 12. Such connecting device 22 is particularly visible on Figure 2. The function of the connecting device 22 is to connect the connecting tab of the first polarity 14 to the DC link capacitor, in addition to the direct connection between the DC link capacitor and the connecting tab of the second polarity 16 which was described hereinbefore. The connecting device 22 is a metal piece of the switching cell 1; as such, it can be manufactured out of copper or out of aluminium.

The connecting device 22 has at least one connecting part 24 and at least one covering part 26. Its connecting part 24 is configured to be in contact with the connecting tab of the first polarity 14, while the covering part 26 covers at least the space S between the connecting tab of the first polarity 14 and the connecting tab of the second polarity 16 which is next to it.

On Figure 3, the power module 2, the DC link capacitor and the connecting device have been spread out, with dotted lines indicating their positions respective to each other.

The connecting device 22 will now be described in more details relatively to Figure 2. The connecting device 22 as is shown here is configured to be connected to the connecting tabs of the first polarity 14 of the three power modules 2A, 2B, 2C, meaning to three distinct connecting tabs of the first polarity 14. The connection device 22 comprises a shared body 28 of a substantially rectangular shape. This shared body 28 mainly extends according to the transversal direction T. The connecting device 22 has a first transversal end 30 and a second transversal end 32 opposite to it according to this transversal direction T. Each transversal end 30, 32 is equipped, on the shared body 28, with a positioning hole 34, which is intended to cooperate with a positioning pin 36 on the main body 10 of the DC link capacitor 4, as shown on Figure 3. More precisely, the positioning pin 36 of the DC link capacitor 4 can be inserted in the positioning hole 34 of the connecting device 22 in order to position this connecting device 22 with regard to the DC link capacitor 4. The connecting device 22 thus cooperates with the DC link capacitor 4 *via* their respective positioning hole 34 and positioning pin 36. Alternatively, the positioning pin 36 could be on the connecting device 22 while the positioning hole 34 is on the DC link capacitor. Once the connecting device 22 has been positioned on the DC link capacitor 4, it can be welded to both the DC link capacitor 4 and the power module 2. The connecting device 22 is for instance welded to at least the connecting tab of the first polarity 14 of the power module 2.

Branches 38 extend from the shared body 28 of the connecting device 22. While the shared body 28 is oriented towards the DC link capacitor 4, the branches 38 extend along the longitudinal direction L towards the power module 2. There are as many branches 38 as there are power modules 2; the connecting device 22 is here illustrated with three branches 38A, 38B, 38C corresponding to the first, second and third power modules 2A, 2B, 2C, but there could be a single branch 38 in embodiments with a single power module 2.

The first branch 38A extends from the shared body 28 near the first transversal end 30, whereas the third branch 38C extends from the shared body 28 near the second transversal end 32. The second branch 38B is located between the first branch 38A and the third branch 38C, and it is substantially equidistant from them. The first branch 38A is in contact with the connecting tab of the first polarity 14 of the first power module 2A, the second branch 38B is in contact with the connecting tab of the first polarity 14 of the second power module 2B, and the third branch 38C is in contact with the connecting tab of the first polarity 14 of the third power module 2C. It is more particularly the connecting part 24 of each branch 38A, 38B, 38C which is in contact with the connecting tab of the first polarity 14 of the corresponding power module 2.

Similarly, the first branch 38A covers the space S between the connecting tabs 14, 16 of the first power module 2A, the second branch 38B covers the space S between the connecting tabs 14, 16 of the second power module 2B, and the third branch 38C covers the space S between the connecting tabs 14, 16 of the third power module 2C. It is more precisely the covering part 26 of each branch 38A, 38B, 38C which covers the space between the connecting tabs 14, 16 of the corresponding power module 2.

The connecting device 22 has an upper side 40 and a lower side 42, the lower side 42 being its side facing the connecting tabs 14, 16 while the upper side 40 is opposite to it. The upper side 40 and the lower side 42 are joined by an edge 44 which corresponds to a side of the connecting device 22 facing the front face 10 of the power module 2. A thickness of the connecting device 22, measured between its upper and lower sides 40, 42 and substantially perpendicular to them, is between 0,3 and 0,9 millimetre. The thickness of the connecting device 22 is preferably of 0,6 millimetre, notwithstanding any manufacturing tolerances.

While the thickness of the connecting device 22 may be constant from its first transversal end 30 to its second transversal end 32, the connecting device 22 is not flat; in other words, it does not extend in a single plane as is the case for the connecting tabs 14, 16 of the power module 2 for instance. As a result, there is an offset within the connecting device 22.

The offset is more precisely between the connecting part 24 and the covering part 26. The connecting part 24 and the covering part 26 therefore mostly extend in two different planes which are substantially parallel to one another as well as parallel to the connection plane of the connecting tabs 14, 16. The connecting part 24 and the covering part 26 are joined together by a bent portion 46, which is a curve within the connecting device 22. Between the connecting part 24 and the covering part 26, the bent portion 46 is bent towards the lower side 42 of the connecting device 22. In other words, the covering part 26 extends mainly in the same plan than the branch 38 it is attached to, whereas due to the bent portion 46 the connecting plane 24 is in a different plane. This different plane is here a lower plane when the switching cell 1 is installed in the automotive vehicle.

When there are two connecting tabs of the first polarity 14 surrounding a single connecting tab of the second polarity 16 for a given power module 2, the corresponding branch 38 of the connecting device 22 comprises a single covering part 26 as well as two connecting parts 24. The two connecting parts 24, namely a first connecting part 24A and a second connecting part 24B, extend transversally from opposite sides of the covering part 24. More precisely, the first connecting part 24A extends from the covering part 24 towards the first transversal end 30 of the connecting device 22 whereas the second connecting part 24B extends towards its second transversal end 32. Each of the first connecting part 24A and the second connecting part 24B is joined to the covering part 24 *via* a bent portion 46. The two connecting parts 24A, 24B extend in the same plane.

As mentioned before, the connecting part 24 of the connecting device 22 is in contact with the connecting tab of the first polarity 14; when applicable, each of the two connecting parts 24A, 24B is in contact with one of the two connecting tabs of the first polarity 14 of a given power module 2. More precisely, the lower side 42 of the connecting part 24 is layered over an upper face 48 of the connecting tab of the first polarity 14. The connecting part 24 can be in contact with the upper face 48 of the connecting tab of the first polarity 14 in its entirety. In other embodiments, the connecting part 24 is in contact with only a portion of the upper face 48 of the connecting tab of the first polarity 14, as the bent portion 46 of the connecting device 22 is aligned with the connecting tab of the first polarity 14 according to a vertical direction V. In these embodiments, as a result of the bent portion 46 the offset extends away from the upper face 48 of the connecting tab of the first polarity 14.

The covering part 26 covers at least the space S between two connecting tabs 14, 16. When the power module 2 comprises two connecting tabs of the first polarity 14 surrounding one connecting tab of the second polarity 16, the covering part covers both the first space S1 between one of the connecting tabs of the first polarity 14 and the connecting tab of the second polarity 16 and the second space S2 between this connecting tab of the second polarity 16 and the other connecting tab of the first polarity 14. Due to the offset caused by the bent portion 46 or bent portions 46, the covering part 26 is not in contact with the connecting tab of the second polarity 16; it extends over it at a distance from it. More precisely, the covering part 26 integrally covers the connecting tab of the second polarity 16 without touching it.

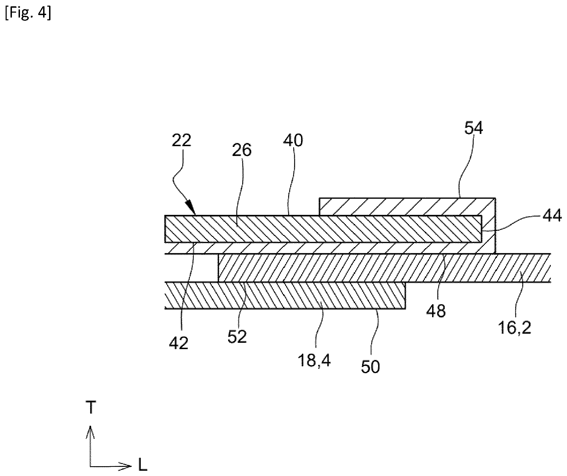

In addition, the covering part 26 is at a distance from the linking tab 18 of the DC link capacitor 4; as can be seen on Figure 4, the connecting tab of the second polarity 16 is between the connecting device 22 and the linking tab 18. In other embodiments, not illustrated, the linking tab 18 could be between the connecting tab of the second polarity 16 and the connecting device 22. A lower portion 50 of the linking tab 18 would then be in contact with the connecting tab of the second polarity 16, more particularly with its upper face 48, while the upper portion 52 opposite to the lower portion 50 would be at distance from the covering part 26 of the connecting device 22. It has to be noted that such a layout may induce an increase of unwanted stray inductance due to the distance of adjacent tabs of opposite polarity which would no longer be in the same plane, the magnetic fields produced may in this case not be completely compensated.

The resulting space between the connecting tab of the second polarity 16 and the covering part 26 is at least partially filled with an insulating means 54. More specifically, this insulating means 54 covers at least part of the connecting device 22, as shown on Figures 2 and 4. According to the embodiments, the insulating means 54 can be an insulating paper or a coating of an insulating material.

The switching cell 1 comprises one insulating means 54 for each branch 38 of the connecting device 22; as such, there are three insulating means 54 each covering at least part of one of the branches 38A, 38B, 38C.

As can be seen on Figure 2, the insulating means 54 covers the covering part 26 of the connecting device 22. Transversally, this insulating means 54 extends from the bent portion 46 between the first connecting portion 24A and the covering part 26 on the one hand to the bent portion 46 between the covering part 26 and the second connecting portion 24B on the other hand, although the insulating means does not cover the bent portions 46. It is understood that the insulating means 54 does not cover the connecting portions 24A, 24B. On Figure 2, the insulating means 54 has been removed from the first branch 38A of the connecting device 22 for illustrative purposes, but each branch 38A, 38B, 38C is equipped with such insulating means 54.

At least a portion of the insulating means 54 extends along a lower face of the branch 38, covering it on all of its longitudinal dimensions. As such, the insulating means extends from the shared body 28 to a tip of the branch 38 comprising the covering part 26. As shown on Figure 2, the insulating means 54 may extend further than the branch 38 according to the transversal direction T, thus going further than the edges of the branch 38.

As illustrated on Figure 4, the insulating means 54 is U-shaped; as such, it extends over the upper side 40 of the covering part 26, its lower side 42 and its edge 44. When the insulating means 54 is an insulating paper, this insulating paper can be glued on either the upper side 40 or the lower side 42, then bent over the edge 44 and glued on respectively the lower side 42 or the upper side 40.

Thanks to the shape and the dimensions of the insulating means 54, creepage and clearance issues are solved in the corridor 12 between the power module 2 and the DC link capacitor. These creepage and clearance issues are limited thanks to both the U shape of the insulating means 54, covering both sides 40, 42 of the covering part 26, and transversal dimension of the insulating means 54, which extends further than the connecting part 26 and the branch 38. Such transversal dimension of the insulating means thus manages stray inductance both between the connecting part 26 and the connecting tab of the second polarity 16 and between the branch 38 and the linking tab 18.

The present invention thus covers a switching cell comprising a power module and a DC link capacitor, stray inductance risks being limited thanks to a connecting device of the switching device which compensates unwanted magnetic fields.

Many modifications and other embodiments of the invention set forth herein will come to mind to one skilled in the art to which the invention pertains having the benefit of the teachings presented in the foregoing descriptions and the associated figures. Therefore, it is to be understood that the invention is not to be limited to the specific embodiments disclosed and that modifications and other embodiments are intended to be included within the scope of the appended claims. Although specific terms are employed herein, they are used in a generic and descriptive sense only and not for purposes of limitation.

## Claims

1. Switching cell (1) for an automotive vehicle, comprising at least one power module (2, 2A, 2B, 2C), a DC link capacitor (4), and a connecting device (22) between the power module (2, 2A, 2B, 2C) and the DC link capacitor (4), the power module (2) having at least one connecting tab of a first polarity (14) and at least one connecting tab of a second polarity (16), the connecting tabs (14, 16) extending from a face (10) of the power module (2, 2A, 2B, 2C) facing the DC link capacitor (4), the connecting tabs (14, 16) being in a same connection plane and being separated by a space (S), the connecting device (22) comprising at least one connecting part (24, 24A, 24B) in contact with the connecting tab of the first polarity (14) and a covering part (26) covering at least the space (S) between the connecting tabs (14, 16), the covering part (26) being offset from the connecting part (24, 24A, 24B) perpendicularly to the connection plane.

2. Switching cell (1) according to the preceding claim, wherein the DC link capacitor (4) has at least one linking tab (18) extending from one of its sides (20) facing the power module (2, 2A, 2B, 2C), the linking tab (18) being in contact with the connecting tab of the second polarity (16) of the power module (2, 2A, 2B).

3. Switching cell (1) according to the preceding claim, wherein the covering part (26) of the connecting device (22) is at a non-zero distance from the linking tab (18) of the DC link capacitor (4).

4. Switching cell (1) according to any of the preceding claims in combination with claim 2, wherein the linking tab (18) is layered between the connecting tab of the second polarity (16) and the connecting device (22).

5. Switching cell (1) according to any of the preceding claims, wherein the power module (2, 2A, 2B, 2C) comprises one connecting tab of the first polarity (14) and two connecting tabs of the second polarity (16), the connecting tab of the first polarity (14) being arranged between the two connecting tabs of the second polarity (16).

6. Switching cell (1) according to the preceding claim, wherein the connecting device (22) comprises two connecting parts (24A, 24B) each in contact with one of the connecting tabs of the second polarity (16), the two connecting parts (24A, 24B) extending from opposite sides of the covering part (26) and being in a same plane.

7. Switching cell (1) according to any of the preceding claims, comprising a plurality of power modules (2, 2A, 2B, 2C), the connecting device (22) having a shared body (28) and a plurality of branches (38, 38A, 38B, 38C) extending from the shared body (28), each branch (38, 38A, 38B, 38C) being in contact with the connecting tab of the first polarity (14) of a given power module (2, 2A, 2B, 2C) and covering at least the space (S) between the connecting tabs (14, 16) of the given power module (2, 2A, 2B, 2C).

8. Switching cell (1) according to any of the preceding claims, comprising at least one insulating means (54), the insulating means (54) covering at least part of the covering part (26) of the connecting device (22).

9. Switching cell (1) according to the preceding claim, wherein the covering part (26) of the connecting device (22) has an upper side (40), a lower side (42) and an edge (44) joining the upper side (40) and the lower side (42), this edge (44) being substantially parallel to the face (10) of the power module (2, 2A, 2B, 2C) from which the connecting tabs (14, 16) extend and the edge (44) facing this face (10), the insulating means (54) covering at least partly each of the lower side (42), the upper side (40) and the edge (44) of the covering part (26) of the connecting device (22).

10. Switching cell (1) according to any of the preceding claims in combination with claims 7 and 8, comprising a plurality of insulating means (54), each insulating means (54) covering at least part of the covering part (26) of one of the branches (38, 38A, 38B, 38C) of the connecting device (22).

11. Switching cell (1) according to any of the preceding claims in combination with claim 8, wherein the insulating means (54) is an insulation layer, e.g. an insulating paper, coating, etc.

12. Switching cell (1) according to any of the preceding claims, wherein the DC link capacitor (4) has at least one positioning pin (36) and the connecting device (22) has at least one positioning hole (34), the positioning pin (36) and the positioning (34) hole cooperating together.

13. Switching cell (1) according to any of the preceding claims, wherein the connecting device (22) is made out of metal.

14. Switching cell (1) according to any of the preceding claims, wherein the connecting device (22) has a thickness between 0,3 and 0,9 millimetre.

15. Switching cell (1) according to any of the preceding claims, wherein the connecting device (22) is welded to at least one of the connecting tabs (14, 16) of the power module (2, 2A, 2B, 2C).
